# EUROPEAN PATENT SPECIFICATION

(11) **EP 2 325 348 B1**
(45) Date of publication and mention of the grant of the patent: **24.10.2012**
(21) Application number: 09014510.3
(22) Date of filing: 20.11.2009
(51) Int. Cl.: C23C 14/24

(54) **Device and method for thermal evaporation of silicon**
Vorrichtung und Verfahren zur thermischen Verdampfung von Silicium
Dispositif et procédé pour l'évaporation thermique du silicium

(43) Date of publication of application: 25.05.2011
(73) Proprietor: Max-Planck-Gesellschaft zur Förderung der Wissenschaften e.V., 80539 München (DE); CreaTec Fischer & Co. GmbH, 74391 Erligheim (DE)
(72) Inventor: Jeurgens, Lars, 70569 Stuttgart (DE); Fischer, Albrecht, 74369 Löchgau (DE)
(74) Representative: Hertz, Oliver

(56) References cited:
- JP-A- 7 300 666
- JP-A- 11 222 667
- JP-A- 2006 348 337
- US-A1- 2006 278 167

## Description

### Subject of the invention

The invention relates to an evaporator cell, which is adapted for evaporating a high-melting material, like in particular silicon. Furthermore, the invention relates to a coating installation including such an evaporator cell. Furthermore, the invention relates to a process for evaporating a high-melting material, like e.g. silicon. Preferred applications of the invention are in the field of physical vapor deposition of thin-film silicon.

### Technical background

Thin-film silicon (with thicknesses from the nanometer scale up to several micrometers) is a key material in numerous microelectronic technologies, such as high-performance thin-film transistors in advanced large-area electronics, specifically, in active matrix flat-panel displays. Thin-film silicon is also a major candidate for manufacturing low-cost, high-efficiency solar cells and other photovoltaic devices. Current technologies for the deposition of Si thin-films on foreign substrates from a vapor phase can be subdivided into chemical vapor deposition (CVD) and physical vapor deposition (PVD) processes.

In the CVD process, gaseous chemical species (i.e. precursors) react and/or decompose at a substrate surface to produce a desired thin film on its surface. The resulting thin film generally contains impurities from the corrosive gaseous products of the CVD process. Furthermore, increased chemical reaction rates of the precursor and thereby enhanced deposition rates are generally achieved through an increase of the substrate temperature, which is incompatible with the use of heat-sensitive substrate materials such as plastics or paper.

In the PVD process, a target solid gets evaporated from a crucible or sputtered by ion bombardment onto a substrate to form a thin film at its surface. The PVD process can be carried out at a much lower cost at lower deposition temperatures and without corrosive products in the deposited films.

Up to date, the applicability of conventional effusion cell designs for the pure thermal evaporation of high-purity Si out of a crucible is still limited to the doping regime with maximum deposition rates up to about 1 nm/min. Higher evaporation rates in the range of 0.6 - 10 nm/min can still only be achieved by electron- or ion-beam-assisted evaporation techniques. In such electron- or ion-beam-assisted evaporation processes, the kinetic energy of the evaporant particles is increased beyond their thermal energy. Consequently, the enhanced kinetic energy transfer of the deposited particles at the substrate surface may lead to displacements and/or rearrangements of surface atoms, thereby affecting the thin film properties (e.g. surface roughness, morphology and defect structure).

The existing technical problems of deposition of high-purity Si films by pure thermal evaporation out of a crucible at sufficiently high evaporation rates (i.e. > 1 nm/min) are diverse and complex. Most importantly, the vapor pressure of solid Si is much too low to achieve a high-enough flux of Si evaporant onto the substrate material. Higher vapor pressures and thus higher thermal fluxes of the Si evaporant can only be realized by melting the Si inside the crucible material at temperatures beyond the Si melting point of 1410°C. However, liquid and gaseous Si species are very aggressive (i.e. highly reactive) with many crucible materials, as well as with the employed (tungsten or iridium) heating filaments.

Evaporator cells, which are adapted for evaporating high-melting materials having a melting point in particular above 1400°C are described e.g. in US 2006/0278167 A1 and WO 2009/015796. With these evaporator cells, the high-melting material is accommodated in a single cylinder-shaped or cone-shaped crucible, which is made of a tungsten or tantalum metal sheet. The crucible is heated with resistance heating or electron beam heating using a heating device arranged on an outer side of the single crucible. For the following reasons, essential restrictions exist with regard to the evaporation of silicon with the conventional evaporator cells.

Upon cooling down below the Si melting point after each evaporation step, the Si solidifies while the crucible walls are still very hot. Since most high-temperature-resistant crucible materials (e.g. W and Ta, but also Al₂O₃ or BeO) shrink faster than the solidified Si inside, the crucible becomes mechanically stressed upon successive thermal cycling through the solid-liquid Si phase transformation. As a result, the crucible will expand and eventually break (i.e. fracture) after one or more evaporation steps. Then, highly-reactive liquid and gaseous Si species penetrate through the small cracks of the crucible into the surrounding effusion cell construction and totally destruct it.

At present, only crucibles out of vitreous carbon (VC) and silicon carbide (SC) have thermal expansion coefficients, which closely match that of solid Si (i.e. 2.6×10-6 K⁻¹). Indeed large evaporation fluxes of Si have been achieved in practical experiments repeatedly and reproducibly by operating a thermal evaporation source with liquid Si in a VC or SC crucible in the temperature range of 1600° to ~1800°C (i.e. without stressing and eventually breaking of the crucible).

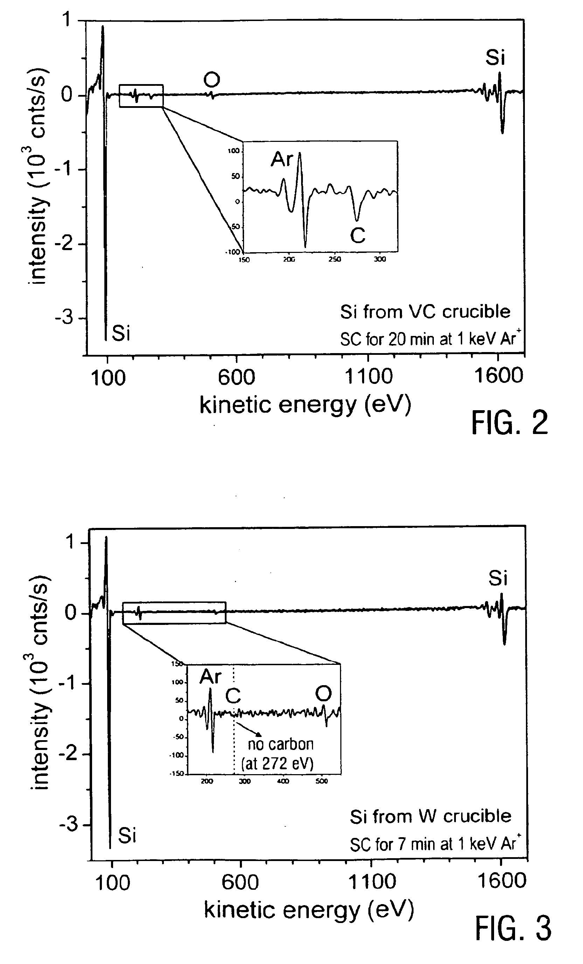

However, experimental investigations by the inventors clearly indicate that the Si thin films evaporated from both VC and SiC crucibles contain a relatively high impurity concentration of carbon (see Fig. 2). Evidently, the VC and SiC crucible materials react with liquid and/or gaseous Si species during the evaporation process. The most abundant gaseous species in equilibrium with solid SiC at temperatures as low as 1800°C are Si(g), SiC₂(g) and Si₂C(g) (see J. Drowart et al. in "Journal of Chemical Physics" Vol. 29, 1958, p. 1015-1021), which will all be incorporated in the evaporated Si thin film during the evaporation process. The resulting high-dopant concentrations of carbon deteriorate the electrical and optical properties of Si and are therefore unwanted in most Si-based thin-film technologies.

Therefore, although Si thin films can be repeatedly deposited at reproducibly high rates by thermal evaporation from VC or SiC crucibles, the high carbon dopant concentration in the resulting Si thin films makes them ineligible for most applications in current and future microelectronic and solar technologies.

An evaporator cell having a structure with an inner crucible, a heating device and an outer case is disclosed in JP 2006 348337 A.

### Objective of the invention

The objective of the invention is to provide an improved evaporator cell being capable of avoiding restrictions and limitations of the conventional techniques. In particular, the evaporator cell is to be capable of evaporating silicon under practical conditions including a plurality of heating cycles and/or with improved purity. Furthermore, the objective of the invention is to provide an improved method for evaporating a high-melting material, like e.g. silicon, avoiding disadvantages of the conventional evaporating methods.

### Summary of the invention

These objectives are solved by an evaporator cell and a method for evaporating a high-melting material comprising the features of the independent claims. Preferred embodiments and applications of the invention are defined in the dependent claims.

According to a first aspect of the invention, the above objective is solved by an evaporator cell (effusion cell) in particular having a first crucible accommodating the material to be evaporated, a second crucible accommodating the first crucible and a heating device being arranged on an outer side of the second crucible and heating the first and second crucibles. The first and second crucibles are arranged such that a spacing is formed between the outer wall of the first crucible and the inner wall of the second crucible. The first crucible provides a first evaporation volume, which is adapted for receiving the material (evaporant) to be evaporated and has an opening through which the material can be evaporated. The second crucible is capable of evaporating material as well. The spacing serves as a second evaporation volume with an opening through which material can be evaporated in parallel to an evaporation from the first crucible. Preferably, the second crucible is shielding the heating device from the first crucible.

According to the invention, the second crucible advantageously fulfils multiple functions:
1. The second crucible can effectively shield the heating device and other parts of the evaporator cell from direct contact with the aggressive liquids and gaseous (evaporated) species in the first crucible.
2. The spacing between the outer wall of the first crucible and the inner wall of the second crucible serves as an additional evaporation source of any material, which is unintentionally transferred from the first to the second crucible. For example, if the first crucible should have a (micro)crack or some other leakage due to mechanical stresses (e. g. after thermal cycling), material migrating through the crack is collected in the second crucible and directly evaporated therefrom. Consequently, the quantity of material, which could unintentionally accumulate into the second crucible, is kept below the critical volume, which would destroy the second crucible during thermal cycling. As such, the mechanical stability of the combination of the first and second crucibles is guaranteed under practical conditions with multiple cycles of melting and solidification of the evaporant, e.g. Si.
3. The spacing between the first and second crucibles is capable of accommodating geometrical changes of the first crucible, while keeping the second crucible unstrained and undeformed.
4. The heating device on the outer side of the second crucible is adapted for indirect, homogeneous heating of the first crucible via the second crucible.

According to a second aspect of the invention, the above objective is solved by a method for evaporating a high-melting material, in particular silicon, wherein the above evaporator cell according to the first aspect is used. The material to be evaporated is filled into the first crucible. The first crucible is indirectly, homogeneously heated by the heating device through the second crucible. The material to be evaporated is melted and evaporated in the first crucible and transferred to a substrate to be coated. Residual portions of the material being migrated to the second crucible are evaporated from the second crucible to the substrate.

The first and second crucibles (or: inner and outer crucibles) represent a double wall crucible design, wherein an evaporation volume is formed between the outer side of the first crucible and the inner side of the second crucible. This relationship can be obtained with various geometries and/or structures. According to a first variant, both first and second crucibles can be connected to each other with a fixed connection. In this case, both crucibles provide an integral component, which can be made of one single or multiple materials. This variant can have advantages in terms of mechanical stability of the evaporator cell. According to a second variant, the first and second crucibles are provided as separate components without a fixed mechanical connection. In this case, the first crucible can be set into the second crucible in a separable manner. Advantageously, such a crucible arrangement facilitates a replacement of the first crucible, e.g. for maintenance purposes or for adapting the evaporator cell to a particular evaporation task. With the above second variant, the first crucible is preferably loosely inserted in the second crucible. The inventors have found that the indirect, homogeneously heating of the first crucible through the second crucible can be easily realized, even without an extended mechanical contact between both crucibles.

With a preferred embodiment of the invention, the first crucible is positioned within the second crucible using at least one support pin being arranged at a bottom portion of the second crucible. As an example, one single support pin may be fixedly connected with one of the first and second crucibles, preferably at the bottom portion of the second crucible. Further support pins may be arranged at the bottom portion or for aligning purposes in the spacing between the first and second crucibles. According to a further preferred feature of this embodiment, the first crucible can be provided with a spacer, which is arranged between side wall portions of the first and second crucibles. Preferably, the spacer is circumferentially arranged at the opening (mouth) of the first crucible, e.g. by a rim or rim portions extending towards the second crucible. Alternatively, the spacer can be provided on an inner side of the second crucible surrounding a side wall portion of the first crucible adjacent to the opening thereof.

According to a particularly preferred embodiment of the invention, the dimensions of the first crucible are selected such that forces exerted by solidifying silicon upon thermal cycling can be repeatedly accommodated without fracturing the crucible. To this end, a wall thickness of the first crucible and a cross-sectional inner dimension (e.g. inner diameter) thereof are selected such that a relative thickness quotient of the wall thickness and the inner dimension is above 1/4, particularly above 1/3, e. g. 1/2. The inventors have found that the first crucible having a relative thickness quotient above these limits has an essentially improved stability even with practical application conditions.

The provision of the evaporator cell with the above specified relative thickness quotient can be implemented without the provision of the second crucible. According to this aspect , an evaporator cell is proposed having a single crucible design and a heating device, wherein the relative thickness quotient is above 1/4.

Preferably, the first and second crucibles are made of a transition metal having a melting point above 3000°C. As a preferred example, the first crucible is made of tungsten. As a further preferred example, the second crucible is made of tungsten or tantalum or a combination thereof.

According to a further preferred embodiment of the invention, the first and second crucibles have a cylindrical or a conical form. The double-wall design of the first and second crucibles preferably represents a coaxial structure. The longitudinal, in particular cylindrical or conical form has advantages in terms of arranging a plurality of evaporator cells in a coating installation side by side, while each of the evaporator cells is capable of accommodating a relative large quantity of material.

The coating installation provided with at least one evaporator cell according to the first aspect of the invention, represents a further independent aspect of the invention.

Preferably, the heating device is structured and controlled as described in US 2006/0278167 A1 or WO 2009/015796, which are introduced into the present specification by reference. Accordingly, the heating device preferably comprises a heating resistor being arranged for a multi-sided resistance heating of the second crucible. Additionally, the heating resistor is provided as an electron emitter for electron beam heating of the second crucible. According to the invention the first and second crucibles have longitudinal extensions and the heating device is preferably arranged along the longitudinal extension on an outer side of the second crucible.

According to a further advantageous feature of the invention, the evaporator cell is free of ceramic parts, in particular in the portion heated by the heating device. In particular, any carrying components supporting the first and/or second crucibles and the heating device are made without ceramic parts. As an advantage, impurities in the flux of evaporated material, which otherwise could be released from ceramic materials are completely avoided.

Further important features of the invention, which preferably are implemented as described in US 2006/0278167 A1 or WO 2009/015796, comprise the provision of a temperature measuring device, in particular a thermocouple, which preferably is arranged in a neighbourhood of the bottom of the second crucible, a thermally insulating holding device to which the first and second crucibles are connected, and a control device being arranged for adjusting the heating device. Preferably, the control device includes first and second control circuits for adjusting the resistance heating and electron beam heating operations, respectively. Furthermore, the temperature measuring device is preferably connected with the control device.

The invention has the following further advantages. Firstly, the present invention is a novel high-temperature effusion cell design for the deposition of high-purity silicon thin films on foreign substrates by pure thermal evaporation at reproducibly high deposition rates under high vacuum conditions. The thermal evaporation source can be fitted with both single-wall or double-walled crucible designs, which very effectively shield the heating resistor (filaments) from the highly-reactive Si vapor phase. Most importantly, the constructions of the single- or double-walled Ta|W-based crucibles can be optimized such to resist the repeated thermal cycling of the effusion cell through the liquid-solid Si phase transformation. The evaporator cell can be operated at temperatures in the range of 1600 - 2000°C, while producing a very clean and constant Si flux as high as -20 nanometers per minute (nm/min; as determined for a crucible volume of 10 cm³). The high-temperature effusion cell invention is ideally suitable for the relatively fast deposition of high-purity Si thin films on heat-sensitive substrate materials such as glass, plastic or even paper at low temperatures (< 350 K) by thermal evaporation under ultra-high-vacuum conditions.

The technical problems due to the stress-induced expansion of the W or Ta inner crucible upon successive thermal cycling of the effusion cell through the liquid-to-solid Si phase transformation (see above section "Technical background") are successfully dealt with in the high-temperature effusion cell invention by:
1. positioning the inner W or Ta crucible inside a larger outer crucible of Ta or W. If small cracks are formed in the inner crucible after successive evaporation steps, all liquid and gaseous Si species penetrating through these cracks of the inner crucible are collected within and subsequently evaporated from the outer crucible, thereby effectively shielding the surrounding effusion cell construction from these highly reactive Si species, and, according to a preferred embodiment, also
2. adopting a single-wall crucible design of Ta or W, which dimensions (in particular its wall thickness and diameter) are optimized with respect to the total volume of Si filled inside. In this way, the forces exerted by the solidifying Si phase upon thermal cycling of the cell can be repeatedly accommodated without fracturing of the crucible.

Furthermore, for both the single- and double-walled crucible designs, the shape of the (outer) crucible can be optimized such that the filaments of the heating system inside the hot-zone of the cell are effectively screened from the high-reactive Si vapor species produced during the evaporation process.

Finally, to reduce the partial pressure of nitrogen and other constituting elements during the evaporation process, the heating system of the effusion cell can be revised (as compared to a conventional high-temperature effusion cell design) by omitting ceramic parts inside the hot zone of the effusion cell.

### Brief description of the drawings

Further features and advantages of the invention are described in the following with reference to the attached drawings, which show in:
- Figures 1A and 1B:: schematic illustrations of a preferred embodiment of the inventive evaporator cell;
- Figures 2 and 3:: experimental results illustrating advantages of the inventive evaporator cell and evaporation method;
- Figure 4:: a schematic illustration of a coating installation of the invention; and
- Figure 5:: an example of an evaporator cell with an optimized relative thickness quotient.

### Preferred embodiments of the invention

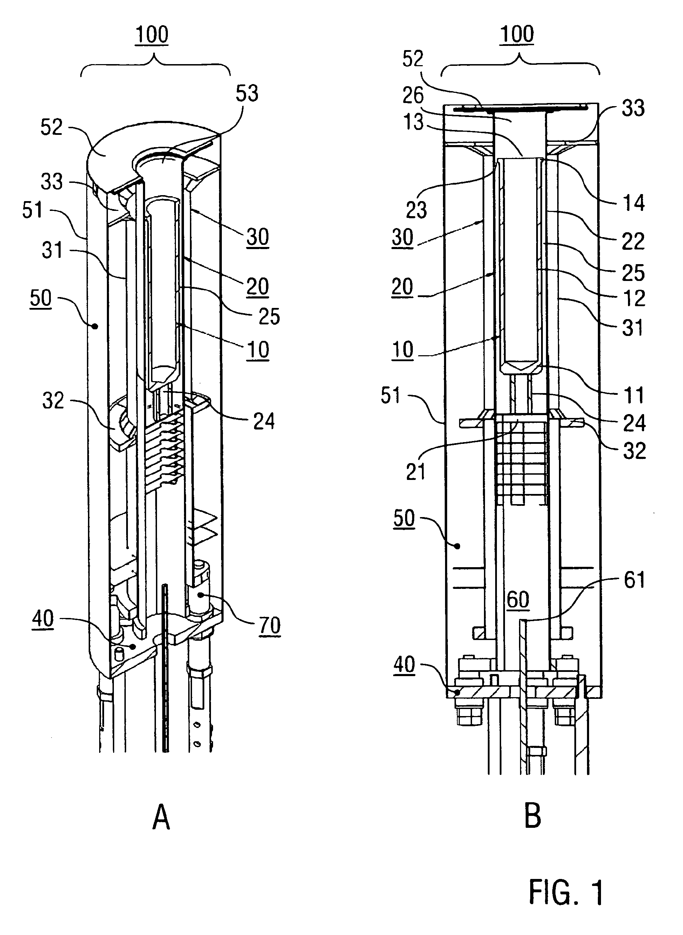

The inventive evaporator cell 100 schematically shown in perspective (A) and sectional (B) view in Figure 1 comprises a first crucible 10, a second crucible 20, a heating device 30, a holding device 40, a shielding device 50, a temperature measuring device 60 and a cooling device 70. These components of the evaporator cell 100 are connected with a power source, a control device and a cooling medium source (not shown) as it is known from conventional evaporator cells.

The first crucible 10 being provided for accommodating the material to be evaporated has a cylindrical (or partly conical) shape extending from a first crucible bottom 11 via a first crucible side wall 12 to a first crucible opening 13. The inner volume of the first crucible 10 represents a first evaporation volume. The first crucible opening 13 is surrounded by a circumferential rim 14, which provides a spacer aligning the first crucible 10 within the second crucible 20. The first crucible 10 consists of a single- or multilayer material made of a transition metal, like e.g. tungsten or a tantalum-tungsten combination. With an inner volume of about 10 cm³, the dimensions of the first crucible 10 can be selected as follows: inner diameter: 1,3 cm, wall thickness: 0,03 cm, axial length of the first crucible side wall 12: 7,6. cm, and radial dimension of the rim 14: 2 cm.

The second crucible 20 is geometrically similar with the first crucible 10. Accordingly, with the illustrated example, the second crucible 20 has a cylindrical shape extending from a second crucible bottom 21 via a second crucible side wall 22 to a second crucible opening 23. A support pin 24, e. g. a hollow tube portion, is arranged on the second crucible bottom 21 for carrying the first crucible 10. The inner diameter of the second crucible 20 is larger than the outer diameter of the first crucible 10 so that a spacing 25 is formed between the first and second crucible side walls 12, 22. The spacing 25 represents a second evaporation volume. Furthermore, the inner diameter of the second crucible 20 is larger than the outer diameter of the rim 14, so that a gap (second crucible opening 23 of the second evaporation volume) remains between the inner side of the second crucible side wall 12 and the rim 14. The second crucible 20 consists of a transition metal, like e.g. tungsten and/or tantalum.

The longitudinal length of the second crucible 20 and the length of the support pin 24 are selected such that with the first crucible 10 set into the second crucible 20 an opening channel 26 is formed. Furthermore, the second crucible is surrounding the first crucible such that the heating device is shielded from the first crucible. The opening channel 26 can be provided for directing the flow of the evaporated material towards a substrate (not shown). Alternatively, the opening channel 26 can be omitted e.g. if a longer first crucible 10 or a shorter second crucible 20 are to be used.

The first crucible 10 is loosely inserted into the second crucible 20. The first crucible 10 is provided without a mechanically fixed connection with the second crucible 20, i.e. the first crucible 10 can be drawn out of the second crucible 20 using a simple tool, e.g. for maintenance or changing purposes or for loading the first crucible 10. The first crucible can be capable of a slight tilting relative to the second crucible, which is not critical for the evaporation function of the cell. With the above example, the dimensions of the second crucible 20 can be selected as follows: inner diameter: 0,58 cm, axial length: 5,8 cm, axial length of the support pin: 1 cm.

The heating device 30 comprises a schematically illustrated heating resistor 31, e.g. a resistor wire, which is arranged around an outer side of the second crucible 20. The heating resistor 31 is supported between carrier elements 32, 33, the first of which being connected with the holding device 40, while the second carrier element 33 being attached to the shielding device 50. The heating resistor 31 is electrically insulated from the first and second crucibles 10, 20. Furthermore, it is electrically connected with a power source and a control device (not shown). The diameter of the heating device 20 is e.g. 1,8 cm. The longitudinal extension of the heating resistor 31 is e.g. 7,5 cm.

The holding device 40 is a support structure being configured for carrying both the combination of the first and second crucibles 10, 20 and the heating device 30. As an example, the holding device 40 is made of a hollow tube, e.g. made of tungsten or a ceramic. The holding device 40 is cooled with a cooling device 70 (Figure 1A) including e.g. water cooling. The above components are fastened in an electrically insulated manner to an inner side of the shielding device 50, which comprises a shielding sheet 51 and a shielding cap 52. The shielding device 50 is made of e.g. tantalum. The shielding cap 52 provides a thermal insulation between the evaporator cell 100 and a substrate to be coated. The shielding cap 52 has a central opening 53 through which the vapor flows towards the substrate.

For evaporating silicon with the evaporator cell 100, the following procedural steps are implemented. Firstly, the first crucible 10 is loaded with the silicon material. This loading step can be conducted with the first crucible 10 being inserted in the second crucible 20 or being separated therefrom. Subsequently, with the first crucible 10 inserted in the second crucible 20, the heating device 30 is operated by applying a heating current to the heating resistor 31. In a first (lower) temperature range, a resistance heating can be provided, while in a second (higher) temperature range an electron beam heating can be conducted as described in US 2006/0278167 A1 or WO 2009/015796. With increasing temperature, the silicon material in the first crucible 10 is melted and evaporated. The silicon vapor evaporates through the opening channel 26 and the central opening 53 towards the substrate to be coated.

If cracks are formed in the side wall 12 of the first crucible 10, e.g. due to thermal cycling, melted or evaporated silicon can migrate into the second crucible 20, where it is evaporated through the gap at the rim 14 and the opening channel 26 towards the substrate. As the material in the second crucible 20 is completely evaporated during each heating cycle, any mechanical stress to the second crucible 20 can be avoided. Accordingly, the heating device 30 and the remaining parts of the evaporator cell 100 are completely shielded from the melted or evaporated silicon so that unintended distortions are avoided. As a result, the purity of the coating on the substrate can be essentially improved as described in the following with reference to experimental results obtained by the inventors.

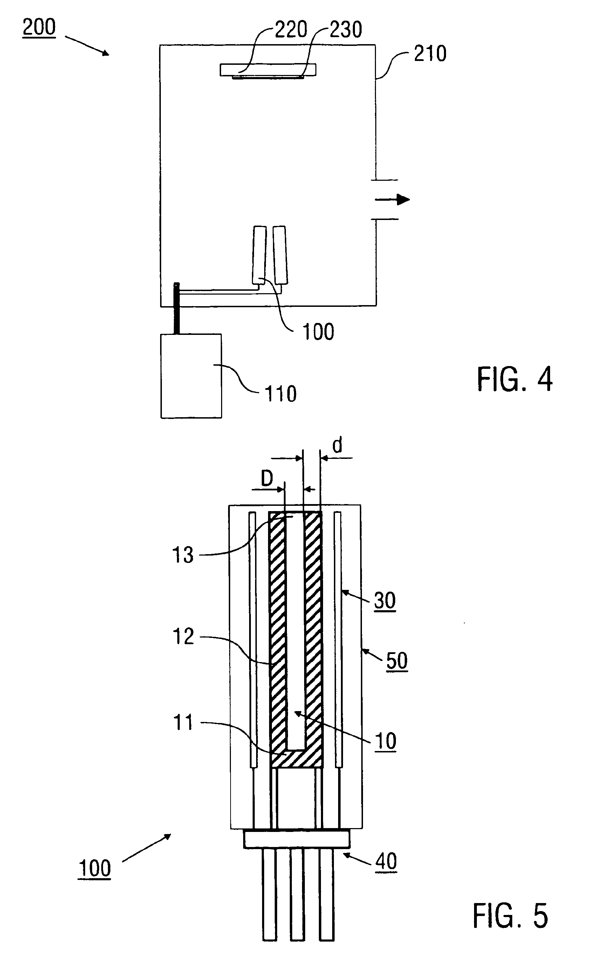

The high-temperature cell design, as employed for test experiments, consists of the following components:
1. High-temperature effusion cell for crucible volumes of 10 cm³.
2. Integrated heating system for regulation of the crucible temperature (as measured at the bottom of the crucible) from room temperature up to 2000°C).
3. No ceramic parts adopted in the hot zone of the cell.
4. Integrated water cooling of the effusion cell around the hot zone of the crucible.
5. 40 mm × 25 mm × 1 mm glass substrate positioned on a sample manipulator in the UHV chamber at a distance of 200 mm from the opening of the effusion cell (see also Fig. 4).

Depending on the test experiment performed, the effusion cell was equipped with one of the following crucible designs:
1. Double-walled crucible design constructed of an outer crucible of Ta (10 cm³) and an inner crucible of W (2 cm³) which was half filled with Si of 6N purity.
2. Double-walled crucible design constructed of an outer crucible of W (10 cm³) and an inner crucible of Ta (2 cm³) which was half filled with Si of 6N purity.
3. Single-walled W crucible (10 cm³), which was half filled with Si of 6N purity.
4. Single-walled Ta crucible (10 cm³), which was half filled with Si of 6N purity.
5. Single-walled conventional VC, Pyrolytic Graphite (PGR) or SiC crucibles (10 cm³), which was half filled with Si of. 6N purity.

The following experimental procedure was adopted for the Si thin-film evaporation tests described in this invention disclosure:
1. Heating up at a constant rate of 30 - 100°C/min to the desired evaporation temperature in the range of 1600°C to 2000°C.
2. Opening of the shutter, while operating the evaporator cell at a constant temperature in the range of 1600°C to 2000°C by using either a constant heating current (in the range of 80 - 95 A with a corresponding heating power of 1000 - 1600 W) or by regulation of the temperature measured at the bottom-side of the crucible with a Eurotherm controller device.
3. Thermal evaporation at the regulated evaporation temperature for various deposition times between 30 minutes and 5 hours.
4. Ex-situ determination of the thickness of the deposited Si films deposited on the glass substrates with a VEECO Dektak 150+ surface profilometer.

Chemical analysis of the deposited Si films by Auger Electron Spectroscopy (Jeol JAMP-7830F, equipped with a field emission electron gun; analyzed area of ~10×10 µm²), as well as with X-ray Photoelectron Spectroscopy (Thermo Scientific ThetaP-robe system, analyzed area of -400 µm in diameter). Prior to the AES and XPS analysis, any surface contaminations on the air-exposed Si thin films were removed by sputtering with 1 kV Ar⁺ ions over an area of about three times larger than the corresponding analysis area.

The experimental investigations performed by the inventors (see Figures 2 and 3) demonstrate that very pure Si thin films, i.e. with impurity concentrations of carbon and other contaminants well below the detection limit of the AES analysis of about 0.1 at.%, can be grown at relatively high deposition rates by operating a thermal evaporation source equipped with tungsten (W) or tantalum (Ta) crucible under ultra-high vacuum conditions in the range of 1600° to 2000°C.

Figure 2 illustrates a chemical analysis by Auger Electron Spectroscopy (AES) of a 900-nm-thick Si thin film grown by thermal evaporation out of a conventional vitreous carbon (VC) crucible at -1680°C. Prior to the in-vacuo AES analysis (analyzed area 10×10 µm²), any surface contamination from the air-exposed Si thin film was removed by 20 minutes of sputtering with 1 kV Ar⁺ ions (sputtered area 300×300 µm²). The remaining oxygen signal in the interior of the Si thin film originates from the reaction of oxygen in the rest vacuum of the deposition chamber with evaporated Si. The detected Ar originates from the sputter-cleaning step prior to the AES analysis. Finally and most importantly, the interior of the Si thin film contains a considerable amount of carbon, which originates from the reaction of the VC crucible with liquid and/or gaseous Si species during the Si evaporation step. Similar results are obtained if a 500-nm-thick Si thin film is grown by thermal evaporation out of a conventional silicon carbide (SC) crucible at ~1670°C.

On the contrary, Figure 3 illustrates a chemical analysis by Auger Electron Spectroscopy (AES) of a 1000-nm-thick Si thin film, which according to the invention has been grown by thermal evaporation out of an inner tungsten (W) crucible at ~1680°C. No carbon could be detected in the interior of the Si thin film by the AES analysis (in contrast to the Si thin films evaporated from VC and SiC crucibles; compare Figure 2). Similar results (i.e. a high purity of the deposited Si thin films) have been obtained for the thermal evaporation out of an inner tantalum (Ta) inner crucible.

The high purity of the thus-evaporated Si thin films can be attributed to the fact that the W- or Ta-silicide phases formed at the crucible walls during the Si evaporation process are not evaporated, but are instead dissociated into a silicon vapor phase and a solid phase of a lower silicide (e.g. ⁵/₇ · TaSi(s) ↔ ⁵/₇ · Tasi_{0.6}(s) + Si(g) (see S.S. Fesenko et al. in "Powder Metallurgy and Metal Ceramics" Vol. 2, 1964, p. 11-17). Consequently, the evaporated Si thin film is not contaminated with Ta and/or W from the crucible material (in contrast to the Si films evaporated from SiC and VC crucibles). In this example, the maximum operation temperature of the thermal evaporation source (i.e. 2000°C) is limited by the melting points of the TaSi and WSi phases, which are produced at the crucible walls during the Si evaporation process.

The effusion cell can be repeatedly operated at temperatures up to 2000°C, while producing a very clean and reproducibly constant Si flux as high as ~20 nm/min (as determined using an inner-crucible volume of only 2cc with a crucible-to-substrate distance of 200 mm; see below). The thermal evaporation source invention is ideally suitable for the relatively fast deposition of high-purity Si thin films on heat-sensitive substrate materials such as glass, plastic or even paper under ultra-high-vacuum conditions.

Figure 4 schematically illustrates a coating installation 200 including at least one inventive evaporator cell 100 being arranged in a vacuum chamber 210 and being connected with a control unit 110. The vacuum chamber 210 is connected with a vacuum pump (not shown) and further components as it is known from conventional PVD devices. A substrate holder 220 is arranged in the vacuum chamber 210 for supporting a substrate 230 to be coated with silicon and possibly further materials. The control unit 110 includes at least one power source, control device and cooling device for operating the at least one evaporator cell 100.

Figure 5 schematically illustrates a sectional view of an alternative evaporator cell 100. With this cell, a single crucible design is provided. In particular, the evaporator cell includes a first crucible 10 and a heating device 30 arranged on a holding device 40 and thermally shielded by a shielding device 50. The first crucible 10 comprises a first crucible bottom 11, a first crucible side wall 12 and a first crucible opening 13. The thickness d of the first crucible side wall 12 and the inner diameter D of the first crucible 10 are selected such that the relative thickness ratio d/D is above 1/4. As an example, with a wall thickness d = 2 mm, the inner diameter D is in the range of 4 mm to 6 mm.

The features of the invention disclosed in the above description, the drawings and the claims can be of significance both individually as well as in combination for the realization of the invention in its various embodiments.

## Claims

1. Evaporator cell (100), in particular for evaporating a high-melting material, comprising:
- a first crucible (10) being adapted for receiving the material to be evaporated and providing a first evaporation volume, and
- a heating device (30) being arranged for heating the first crucible (10), wherein
- the first crucible (10) is arranged in a second crucible (20) surrounding the first crucible (10), so that a spacing (25) is formed between the first and second crucibles (10, 20), wherein the spacing (25) provides a second evaporation volume,
**characterized in that**
- the first and second crucibles (10, 20) have a longitudinal extension and the heating device (30) is arranged along the longitudinal extension on an outer side of the second crucible (20).

2. Evaporator cell according to claim 1, wherein
- the second crucible (20) is shielding the heating device (30) from the first crucible (10).

3. Evaporator cell according to claim 1 or 2, wherein
- the first crucible (10) and the second crucible (20) are fixedly attached to each other, or
- the first crucible (10) and the second crucible (20) are separable from each other.

4. Evaporator cell according to claim 3, wherein
- the first crucible (10) is loosely inserted in the second crucible (20).

5. Evaporator cell according to claim 4, wherein
- the first crucible (10) is carried by a support pin (24) being arranged between bottom portions of the first and second crucibles (10, 20), and
- the first crucible (10) is aligned by a spacer (14) being arranged between side wall portions of the first and second crucibles (10, 20).

6. Evaporator cell according to one of the foregoing claims, wherein
- a relative thickness quotient (d/D) of a wall thickness (d) of the first crucible (10) and a cross-sectional inner dimension (D) thereof is above 1/4, in particular above 1/3.

7. Evaporator cell according to one of the foregoing claims, wherein
- the first crucible (10) is made of tungsten, and/or
- the second crucible (20) is made of tungsten or tantalum.

8. Evaporator cell according to one of the foregoing claims, wherein
- the first and second crucibles (10, 20) have a cylindrical or a conical form.

9. Evaporator cell according to one of the foregoing claims, wherein
- the heating device (30) comprises a heating resistor (31) being adapted for resistance heating.

10. Evaporator cell according to claim 9, wherein
- the heating resistor (31) provides an electron emitter for electron beam heating of the second crucible (20).

11. A coating installation (200) provided with at least one evaporator cell (100) in accordance with one of the foregoing claims.

12. A process for evaporating a high-melting material to be evaporated, using an evaporator cell (100) according to one of the claims 1 to 10 comprising the steps:
- providing the material to be evaporated in the first crucible (10),
- heating the first crucible (10) with the heating device (30) so that a vapor phase of the material is created, and
- depositing the evaporated material on a substrate (230).

13. Evaporating process according to claim 13, wherein
- the material to be evaporated comprises Si.

## Patentansprüche

1. Verdampferzelle (100), insbesondere zum Verdampfen eines hoch-schmelzenden Materials, umfassend:
- einen ersten Tiegel (10), der zur Aufnahme des Materials, das verdampft werden soll, und zur Bereitstellung eines ersten Verdampfungsvolumens angepasst ist, und
- eine Heizeinrichtung (30), die zum Heizen des ersten Tiegels (10) angeordnet ist, wobei
- der erste Tiegel (10) in einem zweiten Tiegel (20) angeordnet ist, der den ersten Tiegel (10) umgibt, so dass ein Abstand (25) zwischen den ersten und zweiten Tiegeln (10, 20) gebildet wird, wobei der Abstand (25) ein zweites Verdampfungsvolumen bereitstellt,
**dadurch gekennzeichnet, dass**
- die ersten und zweiten Tiegel (10, 20) eine Längsausdehnung aufweisen und die Heizeinrichtung (30) entlang der Längsausdehnung auf einer äußeren Seite des zweiten Tiegels (20) angeordnet ist.

2. Verdampferzelle gemäß Anspruch 1, wobei
- der zweite Tiegel (20) die Heizeinrichtung (30) von dem ersten Tiegel (10) abschirmt.

3. Verdampferzelle gemäß Anspruch 1 oder 2, wobei
- der erste Tiegel (10) und der zweite Tiegel (20) fest miteinander verbunden sind, oder
- der erste Tiegel (10) und der zweite Tiegel (20) voneinander trennbar sind.

4. Verdampferzelle gemäß Anspruch 3, wobei
- der erste Tiegel (10) lose in den zweiten Tiegel (20) eingefügt ist.

5. Verdampferzelle gemäß Anspruch 4, wobei
- der erste Tiegel (10) durch einen Trägerstift (24) getragen wird, der zwischen Bodenbereichen der ersten und zweiten Tiegel (10, 20) angeordnet ist, und
- der erste Tiegel (10) durch einen Abstandshalter (14) ausgerichtet ist, der zwischen Seitenwandbereichen der ersten und zweiten Tiegel (10, 20) angeordnet ist.

6. Verdampferzelle gemäß einem der vorhergehenden Ansprüche, wobei
- ein relativer Dickenquotient (d/D) aus einer Wanddicke (d) des ersten Tiegels (10) und einer Querschnitts-Innendimension (D) von diesem größer als 1/4, insbesondere größer als 1/3 ist.

7. Verdampferzelle gemäß einem der vorhergehenden Ansprüche, wobei
- der erste Tiegel (10) aus Wolfram hergestellt ist, und/oder
- der zweite Tiegel (20) aus Wolfram oder Tantal hergestellt ist.

8. Verdampferzelle gemäß einem der vorhergehenden Ansprüche, wobei
- die ersten und zweiten Tiegel (10, 20) eine zylindrische oder eine konische Form aufweisen.

9. Verdampferzelle gemäß einem der vorhergehenden Ansprüche, wobei
- die Heizeinrichtung (30) einen Heizwiderstand (31) umfasst, der für eine Widerstandsheizung angepasst ist.

10. Verdampferzelle gemäß Anspruch 9, wobei
- der Heizwiderstand (31) einen Elektronenemitter für ein Elektronenstrahlheizen des zweiten Tiegels (20) bereitstellt.

11. Beschichtungsanlage (200), die mit mindestens einer Verdampferzelle (100) gemäß einem der vorhergehenden Ansprüche ausgestattet ist.

12. Verfahren zum Verdampfen eines hoch-schmelzenden Materials, das verdampft werden soll, wobei eine Verdampferzelle (100) gemäß einem der Ansprüche 1 bis 10 verwendet wird, umfassend die Schritte:
- Bereitstellung des Materials, das verdampft werden soll, in dem ersten Tiegel (10),
- Heizung des ersten Tiegels (10) mit der Heizeinrichtung (30), so dass eine Dampfphase des Materials erzeugt wird, und
- Abscheidung des verdampften Materials auf einem Substrat (230).

13. Verdampfungsverfahren gemäß Anspruch 12, bei dem
- das Material, das verdampft werden soll, Silizium umfasst.

## Revendications

1. Cellule formant évaporateur (100), en particulier pour évaporer un matériau à point de fusion élevé, comprenant :
un premier creuset (10) qui est adapté pour recevoir un matériau à évaporer et fournir un premier volume d'évaporation, et
un dispositif de chauffage (30) qui est agencé pour chauffer le premier creuset (10), dans laquelle :
le premier creuset (10) est agencé dans un second creuset (20) entourant le premier creuset (10), de sorte qu'un espacement (25) est formé entre les premier et second creusets (10, 20), dans laquelle l'espacement (25) fournit un second volume d'évaporation,
**caractérisée en ce que** :
les premier et second creusets (10, 20) ont une extension longitudinale et le dispositif de chauffage (30) est agencé le long de l'extension longitudinale sur un côté externe du second creuset (20).

2. Cellule formant évaporateur selon la revendication 1, dans laquelle :
le second creuset (20) protège le dispositif de chauffage (30) du premier creuset (10).

3. Cellule formant évaporateur selon la revendication 1 ou 2, dans laquelle :
le premier creuset (10) et le second creuset (20) sont fixés de manière fixe entre eux, ou bien
le premier creuset (10) et le second creuset (20) sont séparables l'un de l'autre.

4. Cellule formant évaporateur selon la revendication 3, dans laquelle :
le premier creuset (10) est inséré sans serrage dans le second creuset (20).

5. Cellule formant évaporateur selon la revendication 4, dans laquelle :
le premier creuset (10) est porté par une broche de support (24) qui est agencée entre les parties inférieures des premier et second creusets (10, 20), et
le premier creuset (10) est aligné grâce à un dispositif d'espacement (14) qui est agencé entre les parties de paroi latérale des premier et second creusets (10, 20).

6. Cellule formant évaporateur selon l'une quelconque des revendications précédentes, dans laquelle :
un coefficient d'épaisseur relative (d/D) d'une épaisseur de paroi (d) du premier creuset (10) et de sa dimension transversale interne (D) est supérieur à 1/4, en particulier supérieur à 1/3.

7. Cellule formant évaporateur selon l'une quelconque des revendications précédentes, dans laquelle :
le premier creuset (10) est réalisé à partir de tungstène, et/ou
le second creuset (20) est réalisé à partir de tungstène ou de tantale.

8. Cellule formant évaporateur selon l'une quelconque des revendications précédentes, dans laquelle :
les premier et second creusets (10, 20) ont une forme cylindrique ou conique.

9. Cellule formant évaporateur selon l'une quelconque des revendications précédentes, dans laquelle :
le dispositif de chauffage (30) comprend une résistance chauffante (31) qui est adaptée pour le chauffage par résistance.

10. Cellule formant évaporateur selon la revendication 9, dans laquelle :
la résistance chauffante (31) fournit un émetteur d'électrons pour le chauffage par faisceau électronique du second creuset (20).

11. Installation de revêtement (200) prévue avec au moins une cellule formant évaporateur (100) selon l'une quelconque des revendications précédentes.

12. Procédé pour évaporer un matériau à point de fusion élevé destiné à être évaporé, à l'aide d'une cellule formant évaporateur (100) selon l'une quelconque des revendications 1 à 10, comprenant les étapes consistant à :
mettre le matériau à évaporer dans le premier creuset (10),
chauffer le premier creuset (10) avec le dispositif de chauffage (30) de sorte qu'une phase vapeur du matériau est créée, et
déposer le matériau évaporé sur un substrat (230).

13. Procédé d'évaporation selon la revendication 13, dans lequel :
le matériau à évaporer comprend du Si.
